# EUROPEAN PATENT APPLICATION

(11) **EP 4 160 242 A1**
(43) Date of publication of application: **05.04.2023**
(21) Application number: 22209743.8
(22) Date of filing: 26.03.2018
(51) Int. Cl.: G01R 33/36, H03D 7/00, H03D 7/14

(54) **INTEGRATED SENSORS**

(30) Priority: 27.03.2017 US 201762476999 P; 27.03.2017 US 201762476981 P; 27.03.2017 US 201762477002 P
(62) Divisional of application: 18777100.1
(71) Applicant: Waveguide Corporation, Cambridge, MA 02142 (US)
(72) Inventor: TRAKIMAS, Michael, Cambridge, 02138 (US); ALEXEYEV, Alexander, Beverly, 01915 (US)
(74) Representative: Marks & Clerk LLP

(57) **Abstract**

Various approaches of receiving signals in integrated circuitry include implementing two successive stages of signal manipulation (304, 306, 308, 310) and employing an interface having an AC coupling network (312) and buffer circuits (314) for decoupling the output impedance and common-mode level of the first stage of signal manipulation (304, 306, 308, 310) from the input impedance and common-mode level of the second stage of signal manipulation (304, 306, 308, 310) without degrading the performance of either stage.

## Description

### CROSS-REFERENCE TO RELATED APPLICATION

This application claims priority to, and the benefit of, U.S. Provisional Patent Application Nos. 62/476,981, 62/476,999, and 62/477,002, all filed on March 27, 2017.

### FIELD OF THE INVENTION

The field of the invention relates, generally, to a sensor in integrated circuitry for receiving signals and, more particularly, to an integrated receiver in a nuclear magnetic resonance (NMR) system.

### BACKGROUND

An NMR system generally includes transceiver circuits for transmitting signals to a tested sample and receiving echo signals therefrom and a processor for analyzing the echo signals in order to obtain imaging and/or material information of the sample. Recently, significant efforts have been devoted to miniaturize traditional NMR systems, in particular NMR transceivers. The numerous advantages of miniaturization include low cost, portability, and the fact that a micro-coil tightly surrounding a small size sample increases the signal quality.

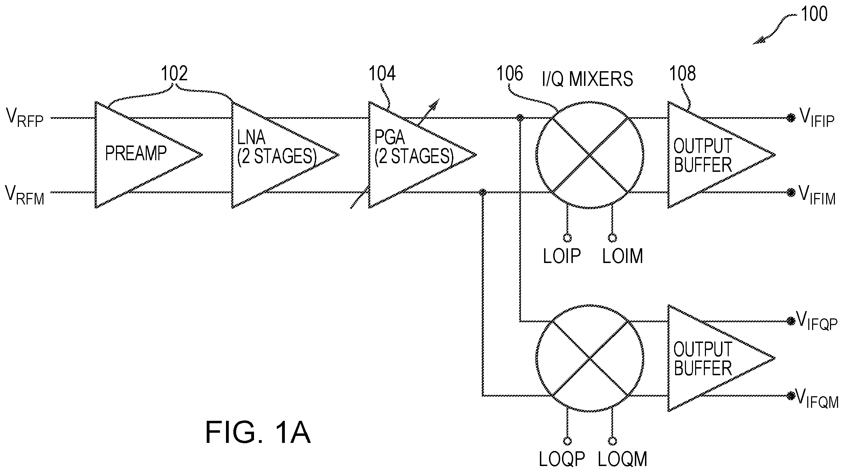

The practical design and construction of miniaturized NMR transceiver circuits, however, may present a number of difficulties. For example, it may be challenging to design an interface between multiple components in a radio-frequency (RF) receiver that provides the overall gain, bandwidth, noise figure and other parameters without degrading the performance when the components are connected. FIG. 1A illustrates an architecture of a conventional RF receiver 100 that includes several stages of amplification: a first stage 102 sets the overall noise performance of the receiver and a second stage 104 provides a certain amount of programmable gain using e.g., a programmable-gain amplifier (PGA) to optimize the dynamic range of the analog-to-digital converter (ADC) used to digitize the output of the receiver. In addition, the RF receiver may incorporate one or more integrated mixers (e.g., I/Q mixers) 106 to down-convert the input signal to a lower frequency and generate both in-phase (I) and quadrature (Q) output signals. Down-converting the frequency of the input signal helps relax the requirements of the ADC used to digitize the signal. Further, a combination of amplification, filtering, and buffering 108 may be employed following the mixer 106 to drive the ADC.

The receiver architecture described above can be implemented in either discrete or integrated form and is applicable to many other applications besides RF. In discrete implementations, the input and output impedance are typically matched to 50 Ω to standardize the interface between different off-the-shelf components. This, however, is not practical for integrated solutions due to size and power constraints. Instead, most integrated solutions require the interface between the components to be custom designed for each chip. This leads to design burdens and increases in cost that can make it impractical to quickly reconfigure the receiver architecture to meet the needs of different applications.

Accordingly, there is a need for an approach that provides a standardized interface between individual components of an integrated receiver to allow different analog front-end configurations to be assembled quickly from a set of standard building blocks. Such an interface preferably does not degrade performance of the overall gain, bandwidth, noise figure and other parameters of each analog front-end configuration when connected.

In addition, designing the integrated mixer(s) 106 with sufficient power and area efficiency that also meets multiple design requirements (such as linearity, bandwidth, dynamic range, noise, gain mismatch, and offset) can be difficult. This is especially true at the lower supply voltages seen in modern semiconductor devices. If these often-conflicting design requirements are not met, the overall performance of the receiver will suffer.

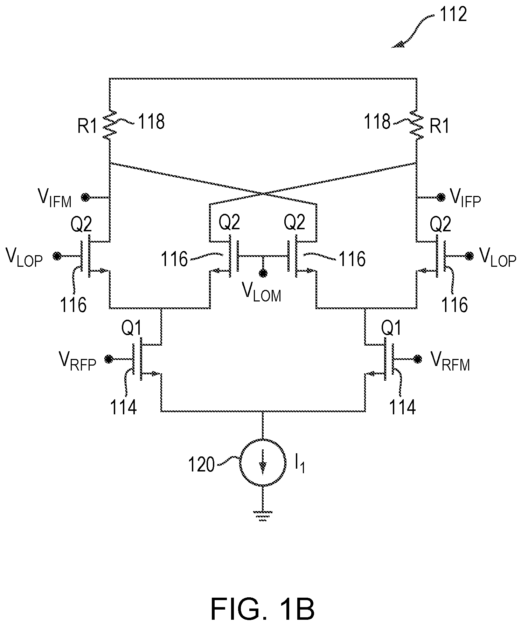

Integrated mixers typically fall into two categories, depending on whether the mixer core circuitry is active or passive. An exemplary active mixer is the conventional Gilbert Cell mixer 112 shown in FIG. 1B. In the Gilbert Cell mixer 112, a radio-frequency (RF) input signal is first converted to a current using the Q₁ devices (e.g., transistors) 114 and subsequently mixed with a local oscillator (LO) signal through the Q₂ devices 116. If inputs to the RF and LO ports include discrete sine waves, an intermediate frequency (IF) output across the load resistors 118 may include components at frequencies of (f_{RF} - f_{LO}) and (f_{RF} + f_{LO}). The up-converted signal at the frequency of (f_{RF} + f_{LO}) may be filtered using a baseband filter following the mixer 112; this leaves a desired baseband output at the frequency of (f_{RF} - f_{LO}). One issue with the Gilbert Cell mixer 112 is the limited headroom and poor linearity resulting from the stacked devices Q₁, Q₂, and the tail current source 120. In addition, the active mixer 112 may generate 1/f noise, which degrades the signal-to-noise ratio of the input signal when it is converted to a baseband frequency. These issues are particularly concerning in modern complementary metal-oxide-semiconductor (CMOS) processes, which have lower supply voltages and larger 1/f noise compared to bipolar devices.

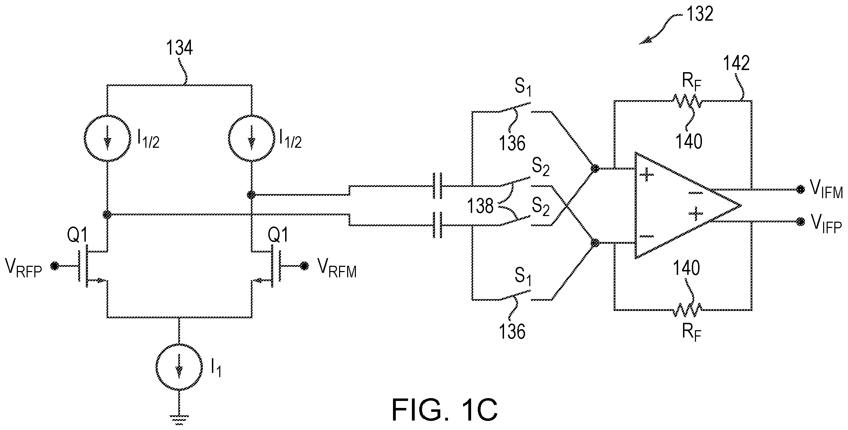

On the other hand, passive mixer architectures have recently become more popular as they offer improved linearity and decreased 1/f noise compared to their active counterparts, especially in lower-voltage CMOS processes. FIG. 1C depicts a typical exemplary passive mixer architecture 132; this mixer is classified as a current-mode mixer since the transconductance stage 134 at the input converts the RF input signal into a current before it is mixed with the LO signal using mixer switches S₁ 136 and S₂ 138. The LO signal in the passive mixer 132 is a rail-to-rail square wave which turns one set of the switches 136, 138 fully on and the other set fully off based on the polarity of the signal. This feature differentiates the passive mixer 132 from the active mixer 112 that has the mixer switches biased in the active region. The output current of the passive mixer switches 136, 138 flows through feedback resistors 140 of the output transimpedance stage 142 to provide a voltage. Capacitors may be placed in parallel with the feedback resistors 140 to filter out the undesired up-converted signals.

Because stacked devices are not needed in the transconductance stage 134 (and the voltage change at the output of the transconductance stage 134 is small in the passive-current mode mixer 132), the linearity of the passive-current mode mixer 132 is generally improved compared to the Gilbert Cell mixer 112. In addition, the 1/f noise is improved in the passive-current mode mixer 132 because no direct current flows through the switches 136, 138.

The current-mode mixer architecture 132, however, cannot easily reject direct-current (DC) offsets from the transconductance stage 134 because the signal is current-mode. As a result, conventional passive current-mode mixers require complex trimming routines to inject current into one of the switching nodes that operate at RF frequencies. Further, because the gain of the current-mode mixer 132 depends on the voltage-dependent transconductance stage 134, non-linearities may still occur. In addition, it may be difficult to match mixer gains at RF frequencies without loading the preceding stage. The latter issue is a particular concern in the quadrature receiver architecture shown in FIG. 1B.

Accordingly, there is also a need for an approach that allows mixers 106 in a receiver to down-convert the received signals to baseband frequencies with improved linearity and decreased 1/f noise while avoiding mismatches in gain, bandwidth, and offset between the mixers.

Further, designing the integrated PGA 104 with power efficiency and featuring a constant gain and well-defined step sizes across process, voltage, and temperature (PVT) variations, as well as good linearity and high dynamic range and bandwidth, is difficult. If these often-conflicting design requirements are not met, then the overall performance of the receiver will suffer.

A PGA is commonly used in the analog front ends of many electronic receivers and analog sensors in various applications. The PGA allows the gain of the front end to be adjusted based on the amplitude of the input signal, thereby enabling the amplitude at the output of the receiver or sensor to be optimized for a wide dynamic range of input signals; this, in turn, allows the signal-to-noise (SNR) ratio to be maximized without allowing large input signal amplitudes to saturate the output stages. In addition, the PGA relaxes the requirements of the analog-to-digital converter (ADC) that often is used to digitize the output signal by optimizing the signal amplitude to fit within the dynamic range of the ADC.

Since the PGA typically has to handle a wide range of signal amplitudes, it is important for the gain of the amplifier, once set, to remain constant as the amplitude of the input signal varies so as to avoid introducing distortion to the signal. In addition, the amplifier gain should stay constant during changes in operating conditions, including PVT variations, to avoid the need to recalibrate the system gain (or to overdesign the programmable gain step size and overall range to compensate for these variations). The programmable step size of the PGA also needs to be well defined over these variations to simplify the gain control algorithm.

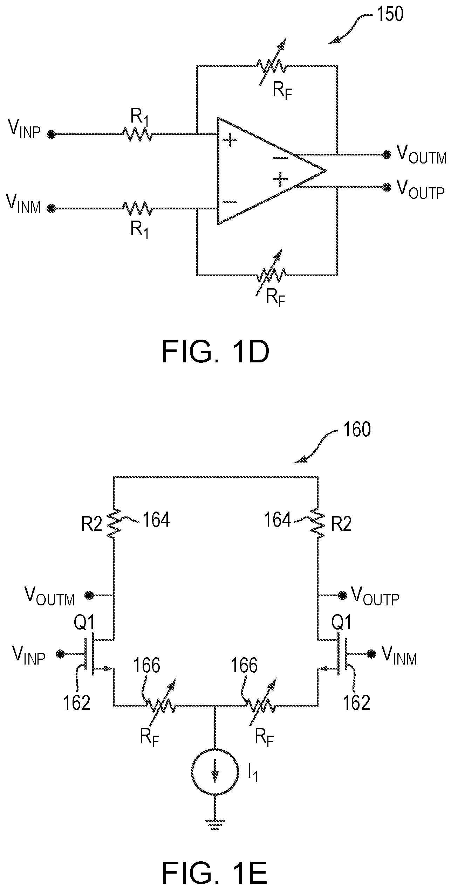

FIG. 1D depicts a conventional closed-loop PGA 150. The gain of the PGA 150 is determined by the impedance ratio R_{F}/R₁ and can thus be adjusted by varying the resistance of the programmable feedback resistor, R_{F}. The programmable resistor R_{F} is commonly implemented as a network of resistors and switches, and the switches are digitally programmed to provide a selected resistance for each switch setting. The resistors R_{F} can also be replaced by capacitors in a switched-capacitor implementation. The PGA 150 in FIG. 1D provides well-defined gain steps as well as high linearity and immunity to PVT variations. The closed-loop PGA 150, however, may suffer from either limited bandwidth or high power consumption.

FIG. 1E depicts a conventional open-loop PGA 160 that provides improved power efficiency for higher-bandwidth applications. The gain of the PGA 160 is determined by the transconductance, gₘ, of a source-degenerated differential pair 162 and the resistance, R₂, of a load resistor 164. The gain can be adjusted by varying the resistance, R_{F}, of a programmable source-degeneration resistor 166 or the resistance R₂ of the load resistor 164. If the transconductance of the input devices is much larger than 1/R₂, the effective transconductance of the source-degenerated differential pair 162 depicted in FIG. 1E is very close to 1/R₂; therefore, the gain of the amplifier is set by the ratio of two resistors 164, 166 similar to the closed-loop architecture depicted in FIG. 1D. In practice, however, it is challenging to meet this requirement at higher bandwidths within a reasonable power budget. As a result, the gain of the PGA 160 depends on the transconductance of the input devices, which varies with signal amplitude as well as the PVT variations. This results in poor performance (e.g., degraded linearity, unstable gain, and ill-defined gain steps) of the open-loop PGA 160 compared to the performance of the closed-loop PGA 150.

Accordingly, there is also a need for an approach that stabilizes the gain of a PGA in a receiver (or another sensor), independent of the amplitudes of the input signals and PVT variations. In addition, the PGA is desired to provide a broad bandwidth with low power consumption.

### SUMMARY

Embodiments of the present invention provide an approach for implementing a standard interface connecting different components in an integrated sensor (e.g., an RF receiver). Interface embodiments of the present invention include circuits that allow each component to "see" similar electrical properties at its input and output; different components may thus be assembled quickly from a set of standard building blocks using the interface and can be easily reconfigured to meet the needs of a wide range of applications and operating conditions. Accordingly, the approach described herein provides an easily reconfigurable receiver architecture and greatly reduces the design burden.

In various embodiments, the interface includes an alternating-current (AC) coupling network and buffer circuits that may precede or follow the AC coupling network. In one implementation, the buffer circuits include source followers; the low input capacitance and output impedance of the source-follower buffers may decouple the tradeoff between the output impedance and input impedance of two successive stages in the sensor and thus advantageously allow each stage to be optimized for noise, gain, bandwidth and power, independent of a subsequent stage. Similarly, the AC coupling network may decouple the output and input common-mode level (e.g., voltage level or current level) of each stage, thereby allowing the output common-mode level (e.g., voltage level or current level) of each stage to be optimized for performance without the need for considering the requirements of a subsequent stage in the integrated sensor/receiver. In addition, the AC coupling network of the interface may remove a direct-current (DC) offset between two stages; this may eliminate the need for offset trim circuits to prevent the DC offset from saturating the output of the sensor/receiver. In some embodiments, the sizes of the capacitors in the AC coupling network are optimized based on the bandwidth requirements of the application so as to achieve an area-efficient design; this is particularly beneficial for parallel applications where multiple analog front-ends are required. In one implementation, the input devices of each stage of the sensor/receiver are biased at the same level using the interface; this allows the architecture design of the sensor/receiver to be simplified.

In one embodiment, one or more switches are employed in one or more stages of the sensor/receiver to provide a coarse gain adjustment for extending the overall programmable gain of the sensor/receiver. To avoid capacitance introduced by the switch(es), the AC coupling network and buffer circuits of the interface may be implemented between successive stages. In some embodiments, the interface is integrated with a mixer (e.g., a voltage-mode passive mixer) for decoupling the driving requirements of the mixer switches from a preceding amplifier (e.g., a PGA). As a result, the same PGA may be used for both stages in a PGA component of the receiver even when the driving requirements of the blocks following them differ.

Further, in some embodiments, the interface is introduced between stages to allow multiple front-end components of the sensor/receiver to connect in parallel to a common component without affecting the performance of each individual component. The interface may prevent the output stage of each front-end component from loading other front-end components and allow the unused front-end components to be disconnected from the common component by simply powering them down; this approach advantageously obviates the need of a switch network implemented in a conventional approach.

In addition, utilizing the interface, a single front-end component may drive multiple parallel components in the sensor/receiver without redesigning the interface therebetween. This architecture may be particularly beneficial in an NMR system for allowing multiple frequencies within the received NMR signals to be analyzed simultaneously. It should be noted that NMR is an exemplary application that may benefit from implementing the reconfigurable sensor/receiver architecture. One of ordinary skill in the art, however, will understand that any suitable sensors and/or applications may implement the sensor/receiver architecture described herein and are thus within the scope of the invention.

Another embodiment of the present invention provides an approach for down-converting received signals to baseband frequencies using one or more voltage-mode passive mixers in combination with a baseband output buffer. In one implementation, the voltage-mode mixer includes a set of CMOS switches driven by source follower buffers, and the baseband output buffer includes an output transimpedance stage. This architecture keeps the received input signals in the voltage domain, thereby allowing any undesired DC offset in the mixer cores to be rejected. In addition, implementations of the voltage-mode passive mixers may simplify the design of circuitry driving the mixer switches (compared to that of circuitry driving a current-mode passive mixer in the conventional approach) and shift the design complexity to the baseband circuits following the mixers. Accordingly, embodiments of the present invention make it easier to match the gain, bandwidth, and offset between two mixers in a quadrature receiver.

In addition, in order to provide the mixer switches with the high-impedance load required by voltage-mode operation, a transconductance stage may be placed between the mixer switches and the output transimpedance stage. In one embodiment, the high-impedance load is more than one hundred times larger than the output impedance of the circuit (e.g., the source follower buffers) driving the mixer switches. Filter capacitors may also be incorporated at the output of the transconductance stage so as to filter out the up-converted signal and shield the transimpedance output buffer from high-frequency feedthrough (e.g., the a frequency of (f_{RF} + f_{LO}) associated with the up-converted signal described in FIG. 1B). This architecture allows a simple current digital-to-analog converter (DAC) to inject an offset trim current at a node between the transconductance and transimpedance stages. Because this node operates at a baseband frequency, the design of the trim DAC may be less complex than that in the current-mode architecture operating at much higher frequencies.

Still another embodiment of the present invention allows the gain of an integrated PGA to be controlled with high linearity and well-defined gain steps over a wide input dynamic range and bandwidth, as well as across a wide range of PVT variations and operating conditions. In one implementation, the PGA includes an open-loop source-degenerated amplifier having input devices and a digitally programmable source-degeneration resistor for setting the gain. In some embodiments, the PGA includes one or more super-transconductance (super-gm) feedback circuits around the input devices of the open-loop source-degenerated amplifier and a constant-transconductance (constant-gm) bias circuit that sets the bias current for all devices in the PGA. This implementation allows the PGA to provide a constant gain and well-defined gain steps over a wide range of the input signals and across various operating conditions. In addition, the combination of these circuits advantageously leads to a more power- and area-efficient design compared to conventional architectures as shown in FIGS. 1D and 1E.

Accordingly, in one aspect, the invention pertains to a sensor for receiving signals in integrated circuitry. In various embodiments, the sensor includes circuitry for applying two or more successive stages of manipulation to the received signals; and an interface having an AC coupling network and buffer circuits for decoupling an output impedance and the first common-mode level of the first one of the successive stages from an input impedance and the second common-mode level of the second one of the successive stages without degrading the performance of either stage. In one implementation, the buffer circuits include source followers. In addition, the AC coupling network includes one or more capacitors and one or more resistors.

In one embodiment, the successive stages include one stage of amplification and one stage of frequency conversion. The stage of amplification may include a programmable-gain amplifier. In addition, the stage of frequency conversion may include a voltage-mode passive mixer. In another embodiment, the successive stages include two stages of amplification. The sensor may include one or more switches connected to one or more of the successive stages for providing a gain adjustment. In addition, the sensor may further include circuitry for applying the third stage of signal manipulation to the received signals; the third stage and the first one of the successive stages may connect in parallel, via the interface, to the second one of the successive stages. In some embodiments, the third stage and the first one of the successive stages include amplification stages and the second one of the successive stages includes a frequency-conversion stage. Alternatively, the third stage and the first one of the successive stages may include frequency-conversion stages and the second one of the successive stages may include an amplification stage.

In another aspect, the invention relates to an NMR apparatus including an NMR coil configured to enclose a sample; a receiver for receiving NMR signals from the sample, the receiver having (i) circuitry for applying two or more successive stages of manipulation to the received NMR signals, and (ii) an interface including an AC coupling network and buffer circuits for decoupling an output impedance and the first common-mode level of the first one of the two successive stages from an input impedance and the second common-mode level of the second one of the two successive stages without degrading the performance of either stage; and a controller configured to analyze the received NMR signals. In one implementation, the buffer circuits include source followers. In addition, the AC coupling network may include one or more capacitors and one or more resistors.

In one embodiment, the successive stages include one stage of amplification and one stage of frequency conversion. The stage of amplification may include a programmable-gain amplifier. In addition, the stage of frequency conversion may include a voltage-mode passive mixer. In another embodiment, the successive stages include two stages of amplification. The NMR apparatus may include one or more switches connected to one or more of the successive stages for providing a gain adjustment. In addition, the NMR apparatus may further include circuitry for applying the third stage of signal manipulation to the received NMR signals; the third stage and the first one of the successive stages may connect in parallel, via the interface, to the second one of the successive stages. In some embodiments, the third stage and the first one of the successive stages include amplification stages and the second one of the successive stages includes a frequency-conversion stage. Alternatively, the third stage and the first one of the successive stages may include frequency-conversion stages and the second one of the successive stages may include an amplification stage.

Another aspect of the invention relates to a method of receiving signals in integrated circuitry. In various embodiments, the method includes providing two or more successive stages of signal manipulation; and providing an interface for decoupling an output impedance and the first common-mode level of the first one of the successive stages from an input impedance and the second common-mode level of the second one of the successive stages without degrading the performance of either stage.

In yet another aspect, the invention pertains to sensor for receiving signals in integrated circuitry. In various embodiments, the sensor includes a voltage-mode passive mixer for down-converting one or more frequencies of the received signals; a baseband output buffer; and a transconductance amplifier coupled to the voltage-mode passive mixer for receiving output signals therefrom and coupled to the baseband output buffer for providing input signals thereto, the transconductance amplifier presenting a high-impedance load to the voltage-mode passive mixer and shielding the baseband output buffer from a high-frequency feedthrough. In one implementation, the voltage-mode passive mixer includes multiple CMOS switches that may be driven by source followers. In addition, the voltage-mode passive mixer may include AC coupling capacitors and/or DC bias resistors for rejecting a DC offset in the voltage-mode passive mixer.

In some embodiments, the sensor further includes one or more filter capacitors, located between the voltage-mode passive mixer and the baseband output buffer, for filtering an up-converted input signal. In addition, the sensor may include a DAC for trimming an offset at an output of the baseband output buffer. In one implementation, the baseband output buffer includes a transimpedance amplifier. Further, the sensor may include one or more feedback resistors coupled to the baseband output buffer for converting the input signals from a current domain to a voltage domain.

Still another aspect of the invention relates to an NMR apparatus including an NMR coil configured to enclose a sample; a receiver for receiving NMR signals from the sample, the receiver including (i) a voltage-mode passive mixer for down-converting a frequency of the received NMR signals, (ii) a baseband output buffer, and (iii) a transconductance amplifier coupled to the voltage-mode passive mixer for receiving output signals therefrom and coupled to the baseband output buffer for providing input signals thereto, the transconductance amplifier presenting a high-impedance load to the voltage-mode mixer and shielding the baseband output buffer from a high-frequency feedthrough; and a controller configured to analyze the received NMR signals.

In some embodiments, the voltage-mode passive mixer includes multiple CMOS switches that may be driven by source followers. In addition, the voltage-mode passive mixer may include AC coupling capacitors and/or DC bias resistors for rejecting a DC offset in the voltage-mode passive mixer. In one embodiment, the NMR apparatus further includes one or more filter capacitors, located between the voltage-mode passive mixer and the baseband output buffer, for filtering an up-converted input signal. In addition, the NMR apparatus may include a DAC for trimming an offset at an output of the baseband output buffer. In one implementation, the baseband output buffer includes a transimpedance amplifier. Further, the NMR apparatus may include one or more feedback resistors coupled to the baseband output buffer for converting the input signals from a current domain to a voltage domain.

In another aspect, the invention relates to a method of receiving signals in integrated circuitry. In various embodiments, the method includes providing a frequency-conversion means for down-converting a frequency of the received signals; providing the first amplification means for converting the signals from a current domain to the voltage domain; and providing the second amplification means coupled to the frequency-conversion means for receiving output signals therefrom and coupled to the first amplification means for providing input signals thereto; the second amplification means presents a high-impedance load to the frequency-conversion means and shielding the first amplification means from a high-frequency feedthrough.

In still another aspect, the invention pertains to a PGA including an open-loop source-degenerated amplifier having a pair of input devices; a pair of super-gm feedback loops, each coupled to one of the input devices for boosting an effective transconductance thereof; and a constant-gm bias circuit for setting a bias current of devices in the open-loop source-degenerated amplifier.

In some embodiments, the PGA further includes electronic devices (e.g., transistors) for forcing a current flowing through the input devices to be constant. In addition, the super-gₘ feedback loops may include transistors. In one embodiment, the constant-gm bias circuit is configured to automatically adjust the bias current so as to keep the effective transconductance of the input devices constant when changes in operating conditions, process, voltage or temperature occur. The PGA may also include a current mirror and a resistor for converting a current signal to a voltage signal at an output of the PGA.

In another aspect, the invention relates to an NMR apparatus including an NMR coil configured to enclose a sample; a receiver having an analog front-end structure and a PGA for adjusting a gain of the front-end structure based at least in part on an amplitude of NMR signals received from the sample, the PGA including (i) an open-loop source-degenerated amplifier having a pair of input devices, (ii) a pair of super-gm feedback loops, each coupled to one of the input devices for boosting an effective transconductance thereof, and (iii) a constant-gm bias circuit for setting a bias current of devices in the open-loop source-degenerated amplifier; and a controller configured to analyze the received NMR signals. The input devices may include a source-degenerated differential pair. In addition, the open-loop source-degenerated amplifier may include a programmable resistor for setting a gain of the PGA.

In some embodiments, the NMR apparatus further includes electronic devices (e.g., transistors) for forcing a current flowing through the input devices to be constant. In addition, the super-gm feedback loops may include transistors. In one embodiment, the constant-gm bias circuit is configured to automatically adjust the bias current so as to keep the effective transconductance of the input devices constant when changes in operating conditions, process, voltage or temperature occur. The NMR apparatus may also include a current mirror and a resistor for converting a current signal to a voltage signal at an output of the PGA.

Another aspect of the invention relates to a method of adjusting a gain of received signals in integrated circuitry. In various embodiments, the method includes amplifying the received signals using an open-loop source-degenerated amplifier having a pair of input devices; boosting an effective transconductance of the input devices; and setting a bias current of devices in the open-loop source-degenerated amplifier.

In general, as used herein, the term "degradation" means a loss of more than 10%, and in some embodiments, 20%, of the amplitude of the gain, bandwidth, noise figure and/or other parameters of the electronic components. Further, reference throughout this specification to "one example," "an example," "one embodiment," or "an embodiment" means that a particular feature, structure, or characteristic described in connection with the example is included in at least one example of the present technology. Thus, the occurrences of the phrases "in one example," "in an example," "one embodiment," or "an embodiment" in various places throughout this specification are not necessarily all referring to the same example. Furthermore, the particular features, structures, routines, steps, or characteristics may be combined in any suitable manner in one or more examples of the technology. The headings provided herein are for convenience only and are not intended to limit or interpret the scope or meaning of the claimed technology.

### BRIEF DESCRIPTION OF THE DRAWINGS

In the drawings, like reference characters generally refer to the same parts throughout the different views. Also, the drawings are not necessarily to scale, with an emphasis instead generally being placed upon illustrating the principles of the invention. In the following description, various embodiments of the present invention are described with reference to the following drawings, in which:
FIG. 1A schematically depicts an architecture of an RF receiver in accordance with the prior art;
FIGS. 1B and 1C schematically illustrate architectures of an active mixer and a passive mixer, respectively, in accordance with the prior art;
FIGS. 1D and 1E schematically illustrate architectures of a closed-loop PGA and an open-loop PGA, respectively, in accordance with the prior art;
FIGS. 2A-2C schematically illustrate an exemplary NMR system in accordance with various embodiments;
FIG. 3A schematically depicts an exemplary standardized interface connecting various components (or stages) of a sensor/receiver in accordance with various embodiments;
FIG. 3B schematically illustrates an architecture of an exemplary standardized interface implemented between various components (or stages) of a sensor/receiver in accordance with various embodiments;
FIG. 4 schematically depicts an exemplary standardized interface integrated with a mixer of a receiver in accordance with various embodiments;
FIG. 5 schematically depicts multiple front-end components of a receiver connected in parallel with the same component via exemplary standardized interfaces in accordance with various embodiments;
FIG. 6 schematically depicts a PGA of a receiver connected to multiple parallel mixers via an exemplary standardized interface in accordance with various embodiments.
FIG. 7 depicts exemplary circuitry implemented in a sensor/receiver in accordance with various embodiments; and
FIG. 8 schematically depicts an exemplary PGA implemented in a sensor/receiver in accordance with various embodiments.

### DETAILED DESCRIPTION

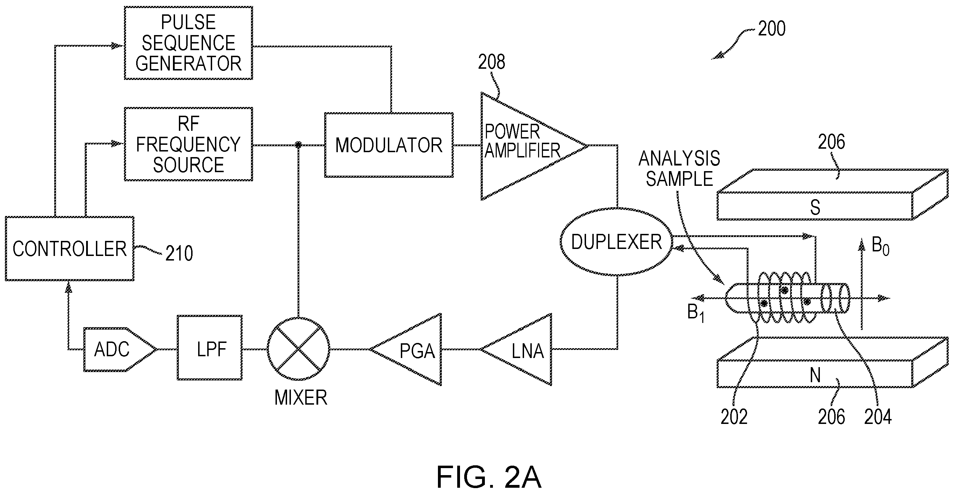

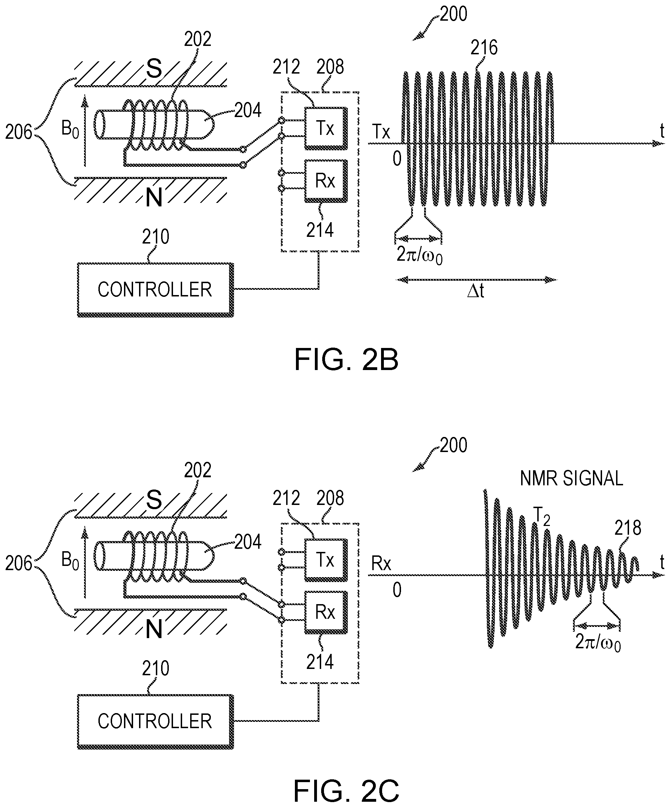

A sensor generally detects events or changes in its environment and sends the information to other electronics for analysis. For example, an NMR system may include an RF receiver to detect echo signals from a sample and subsequently transmit the signals to a processor for analyzing imaging and/or material information of the sample. FIG. 2A illustrates an exemplary NMR system 200 in accordance with various embodiments of the present invention including an NMR coil 202 surrounding a sample 204 being analyzed, a magnet 206 for generating a static magnetic field across the sample 204 and the coil 202, an RF transceiver 208 coupled to the NMR coil 202, and a controller 210 for controlling operation of the RF transceiver 208. In one implementation, with reference to FIGS. 2B and 2C, the transceiver 208 includes a transmitter (Tx) portion 212 for generating and transmitting RF signals to the sample 204 and a receiver (Rx) portion 214 for receiving echo signals from the sample 204.

During NMR measurements, the magnet 206 is activated to generate a substantially homogeneous magnetic field Bo (e.g., within 0.1 parts per million (ppm) or, in some embodiments, within 100 ppm) across the sample 204; individual magnetic moments of the spins in the sample 204 may attempt to align with the applied field Bo. As a result, the magnetic moments of all the nuclei in the sample sum to a net magnetic moment that precesses about the axis of the field Bo at a characteristic Larmor frequency, ω₀, satisfying ω₀ = γ Bo, where γ is a gyromagnetic ratio. Because different nuclei have different values of the gyromagnetic ratio, measuring the Larmor frequency of the sample 204 allows material properties (e.g., the chemical composition) of the sample 204 to be revealed. In various embodiments, to observe precession of the net magnetic moment, the controller 210 causes the transmitter 212 to transmit an RF signal 216 (typically comprising a pulse sequence) having a resonant frequency substantially close (e.g., within ±1%) to the Larmor frequency ω₀ to the coil 202; the coil 202 then generates an RF magnetic field that causes the net magnetic moment of the nuclei in the sample 204 to be "tipped" away from the axis of the static field Bo. Typically, the RF magnetic field has a time-dependent magnitude and is generated in a plane perpendicular to the axis of the static field Bo.

Referring to FIG. 2C, after a predetermined time duration, Δt, the transmitter 212 stops transmission of the RF excitation signal 216, and the coil 202 is switched via, for example, a mechanical switch or an electrical switch (e.g., a transistor) to the receiver 214 for receiving the echo signals from the sample 204. Upon stopping the RF excitation, the nuclear spins within the sample 204 precess around the Bo-axis at the Larmor frequency ω₀; this induces a corresponding signal oscillation. The nuclear spins then slowly lose phase coherence via spin-spin interactions, which manifest themselves in a macroscopic average as an exponential relaxation or damping signal 218 (referred to as "free induction decay") in the precession of the net magnetic moment. The oscillation and relaxation of the NMR signal can be detected by the coil 202. Because the spin-spin interactions are peculiar to the material of the sample 204 being tested, the characteristic time, commonly referred to as T₂, of the relaxation signal is also material-specific. Thus, by measuring the Larmor frequency ω₀ (e.g., for spectroscopy) and/or characteristic time T₂ (e.g., for relaxometry), NMR techniques can be used as an analytic tool in a number of fields, including but not limited to chemical composition analysis, medical imaging, and bio-sensing. An exemplary NMR system is described in U.S. Patent No. 8,643,368, the entire disclosure of which is hereby incorporated by reference.

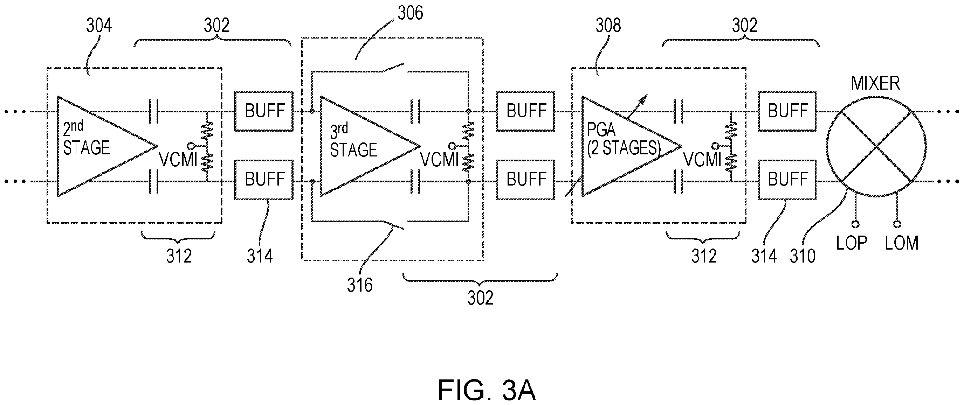

In NMR applications, the strength and size of the magnet 206 as well as the sample size may vary widely from one NMR device to another. Therefore, a flexible architecture that can easily adapt to the resulting changes in bandwidth, gain, and other requirements of the receiver 214 may advantageously reduce design time and cost, and allow the receiver performance to be optimized for each NMR device. Various embodiments of the present invention particularly address the concerns for integrated solutions where the area and power of the receiver are at a premium. For example, referring to FIG. 3A, an exemplary standardized interface 302 may be implemented to connect different components (or stages) 304-310 of an RF receiver. In one implementation, the interface 302 includes an AC coupling network 312 and buffer circuits 314 between two components (e.g., between two stages of amplification 304, 306 or between one stage of amplification 308 and one stage of frequency conversion 310). Although the implementation depicted in FIG. 3A is fully differential, it may also be single-ended without a loss of generality. In addition, it should be noted that in some embodiments, all pairs of successive stages in the RF receiver are decoupled using the interface 302 (as depicted in FIG. 3A). Further, the interface 302 described herein may not be limited to RF receivers or NMR applications only; it may be implemented in any analog front-end structures used in various sensors.

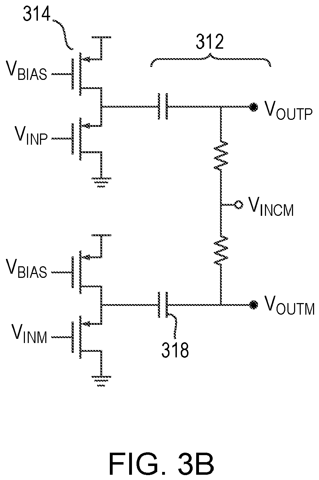

Referring to FIG. 3B, in various embodiments, the buffer circuits 314 include source followers and may precede or follow the AC coupling network 312. The low input capacitance and output impedance of the source-follower buffers 314 may decouple the tradeoff between the output impedance and input impedance of two successive stages and thus advantageously allows each stage to be optimized for noise, gain, bandwidth, and power, among other parameters, independent of a subsequent stage. Similarly, the AC coupling network 312 may decouple the output and input common-mode level of each stage. This design may allow the output common-mode level of each stage to be optimized for performance without the need to conform to the requirements of a subsequent stage. In addition, standardizing the input common-mode level (e.g., voltage level or current level) of each stage using this architecture may allow the input devices of each stage to be biased at the same level, thereby simplifying the overall design. Further, the AC coupling network 312 may remove a DC offset between two stages of the receiver, thus eliminating the need for the offset trim circuits that are employed in a conventional receiver to prevent the offset from saturating the output. In various embodiments, the size of the capacitor 318 in the AC coupling is optimized based on the bandwidth requirements of the application; this provides further advantages in achieving an area-efficient receiver design. Accordingly, the interface 302 may be particularly beneficial for parallel applications where multiple analog front-ends are required.

Referring again to FIG. 3A, in various embodiments, one or more switches 316 may be employed in one or more stages of the RF receiver. For example, the switches 316 may be added around the third gain stage 306 to bypass it and drop the overall gain of the receiver by 20 dB. This provides a coarse gain adjustment to extend the overall programmable gain of the receiver and may be beneficial for applications, such as NMR, where the input signal strength may vary widely. The bypass switches 316 may, however, introduce capacitance; as a result, in conventional designs the output stage of the second stage amplifier 304 is redesigned to avoid degrading the bandwidth. In contrast, various embodiments of the present invention utilize the interface 302 including the AC coupling network 312 and buffer circuits 314 to decouple the introduced capacitance of the third stage 306 from the second stage 304, thereby obviating the need to redesign the second stage 304. In addition, the interface 302 provides another benefit: the same amplifier may be used in successive stages without compromising its performance even when the input impedance of the subsequent stages is different.

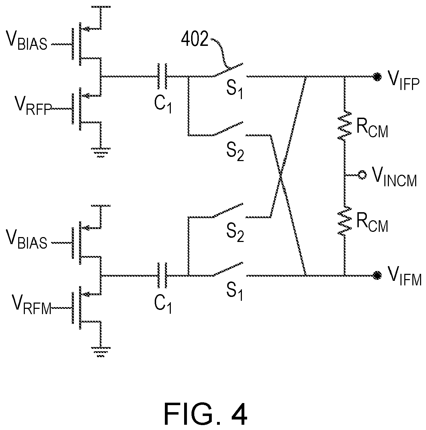

Referring to FIG. 4, in various embodiments, the interface 302 having the AC coupling network 312 and source follower buffers 314 is integrated with a mixer (e.g., a voltage-mode passive mixer) 402. The interface 302 may decouple the driving requirements of the mixer switches 402 from a preceding PGA as shown in FIG. 3A. Accordingly, the same PGA may be used for both stages in the PGA component 308 even when the driving requirements of the blocks following them differ.

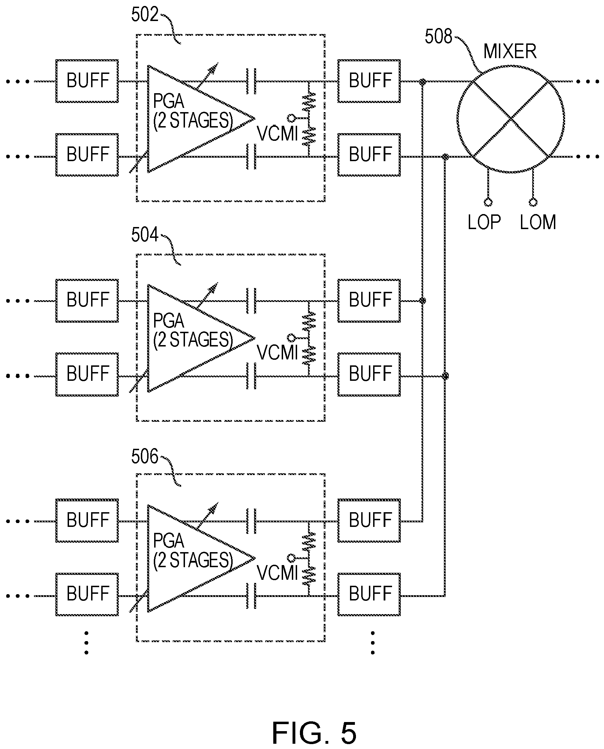

In some embodiments, the interface 302 having the AC coupling network 312 and source follower buffers 314 as described herein is introduced between stages to allow multiple components of a sensor (e.g., an RF receiver) to connect in parallel to a common component without affecting the performance of each individual component. For example, referring to FIG. 5, multiple front-end components 502-506 may be connected in parallel and share the same mixer 508. The AC coupling network 312 and buffers 314 prevent the output stage of each front-end component from loading each other and allow the unused front-end components to be disconnected from the mixer 508 by simply powering them down; this approach obviates the need for a conventional switch network to select one of the components 502-506 to connect to the mixer 508. Accordingly, this design may advantageously save power, area and design time. In an NMR system, this implementation may be suitable for analyzing multiple samples in parallel while sharing the same mixer and ADC.

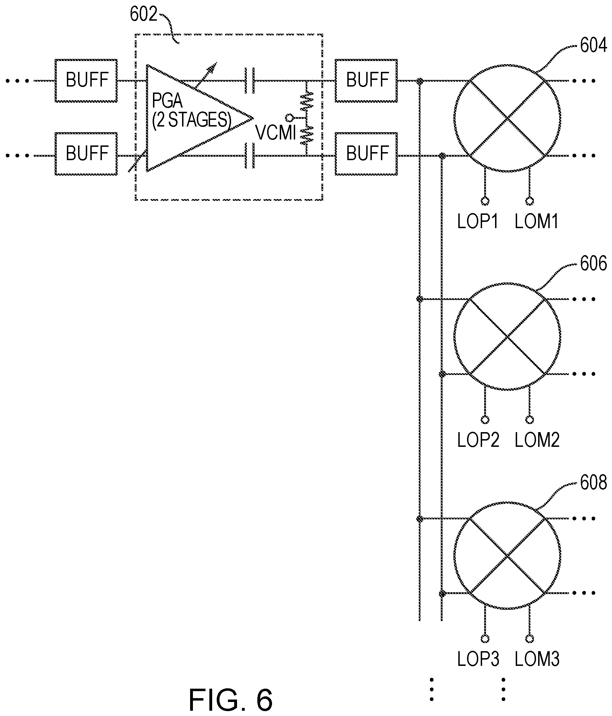

In addition, utilizing the interface 302, a single front-end component may drive multiple parallel components in an RF receiver or other sensors. For example, referring to FIG. 6, the interface 302 having the AC coupling network 312 and buffers 314 may connect the final PGA 602 to multiple parallel mixers 604-608 without causing performance degradation of the PGA 602 due to the added load of the multiple mixers 604-608. This design thus obviates the need to redesign the PGA 602 or the interface between the PGA 602 and the mixers 604-608. In an NMR system, this architecture may advantageously allow multiple frequencies within the received NMR signals to be analyzed simultaneously by independently setting the frequency of the local oscillator (LO) in each mixer.

Accordingly, the interface 302 connecting individual components in an RF receiver or other sensors as described herein may allow different analog front-end configurations to be assembled quickly from a set of standard building blocks, thereby greatly reducing the design time for integrated solutions without compromising performance. In addition, the interface 302 allows the receiver/sensor to be easily reconfigured to adapt to the needs of a wide range of operating conditions and various applications without redesigning the interface between various components.

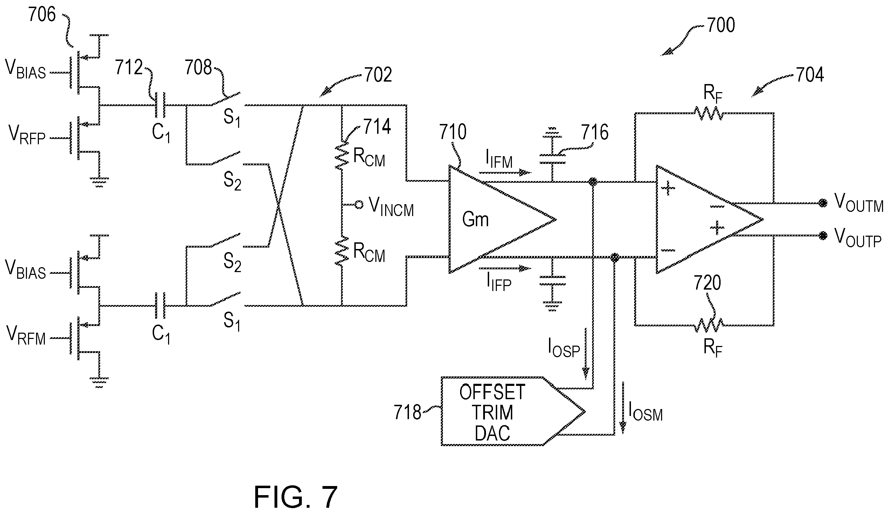

In various embodiments, frequencies of the received RF signals are down-converted to lower baseband frequencies in order to relax the ADC requirements for digitizing the signals for further processing. In various embodiments, with reference to FIG. 7, the frequency conversion is achieved using a circuit 700 including one or more voltage-mode passive mixers 702 in combination with a baseband output buffer 704 (e.g., a transimpedance output buffer). In one implementation, the voltage-mode passive mixer 702 includes source follower buffers 706 providing an input signal (e.g., a received RF signal) to a plurality of mixer switches 708, which may be driven by a rail-to-rail, square-wave LO signal. In addition, the receiver/sensor circuit 700 may include a transconductance (Gm) stage 710; the LO signal may then switch the polarity of the input signal at the input of the transconductance stage 710 based on a polarity of the input signal. The transconductance stage 710 may effectively shield the mixer switches 708 from the transimpedance output buffer 704 and provide a high-impedance load to the mixer switches 708, thereby avoiding degradation of the gain and linearity of the voltage-mode signal. In addition, because the received signal remains in the voltage mode, alternating-current (AC) coupling capacitors 712 (Ci) and DC bias resistors 714 (R_{CM}) may be used in the receiver circuit 700 to effectively reject any undesired DC offset in the mixer 702, thereby optimizing the input bias at the transconductance stage 710. Accordingly, the design complexity of circuitry driving the mixer switches 708 can be simplified in accordance with various embodiments of the present invention. For example, as illustrated in FIG. 7, in one implementation, the driving circuitry can simply be the source followers 706.

In various embodiments, the circuit 700 further includes capacitors 716 placed after the transconductance stage 710 in order to filter out the up-converted input signal. This approach also shields the transimpedance output buffer 704 from high-frequency feedthrough, thereby allowing its bandwidth to be greatly decreased. In the absence of the filter capacitors 716, any signal above the bandwidth of the amplifier in the transimpedance stage 704 may not "see" an AC ground at the input of the transimpedance stage 704, resulting in degraded linearity. In addition, because the input to the transimpedance output buffer 704 operates at a baseband frequency, a simple current DAC 718 may be incorporated to trim the output offset. Implementation of the DAC 718 is a simpler approach compared to the complex trimming routines or circuitry used in a conventional current-mode architecture where an offset trim current is injected into one of the switching nodes that operate at much higher frequencies. Further, the overall offset that needs to be trimmed in various embodiments of the current invention may be much less, since any offset in the mixer itself is rejected by the AC coupling capacitors 712 already and bigger devices may be used in the baseband circuits to reduce their offset and any mismatch.

In some embodiments, feedback resistors 720 are added around the transimpedance output buffer 704 in order to convert signals from the current domain back to the voltage domain. Shielding the transimpedance output buffer 704 from any high-frequency feedthrough greatly simplifies its design compared to that used in conventional current-mode architectures. In addition, implementation of the circuit 700 described herein in a receiver/sensor advantageously allows the transimpedance amplifier that sets the gain of the mixer and output buffer to come after the mixer and operate at a baseband frequency. Therefore, utilization of the circuit 700 in the conventional quadrature receiver (shown in FIG. 1A) may simplify gain matching between two voltage-mode mixers 702 compared to the approach implemented for matching gains between two current-mode mixers.

Accordingly, embodiments of the present invention provide a circuit architecture combining a voltage-mode passive mixer 702 and a baseband output buffer 704 for down-converting received high-frequency signals to baseband frequencies. The core of the voltage-mode mixer 702 may include a set of CMOS switches 708 driven by source follower buffers 706. A transconductance stage 710 and filter capacitors 716 may be strategically placed between the output of the mixer switches 708 and the baseband transimpedance output buffer 704 to provide a high-impedance load to the voltage-mode mixer switches 708 and shield the transimpedance output buffer 704 from high-frequency feedthrough. Compared with conventional mixer architectures, the circuit architecture disclosed herein advantageously shifts most of the design burden from the RF domain to the baseband domain; as a result, a simpler and more power efficient design is achieved.

It should be noted that although the circuitry implementation shown in FIG. 7 is fully differential, it may alternatively be single-ended. In addition, embodiments of the current invention are not limited to implementations in RF receivers and may be used to implement the mixer in numerous analog front-end structures employed in various types of sensors. Further, NMR is an exemplary application that may benefit from implementing the frequency down-converting architecture; one of ordinary skill in the art will understand that many suitable applications may benefit from the sensor/receiver architecture described herein and are thus within the scope of the invention.

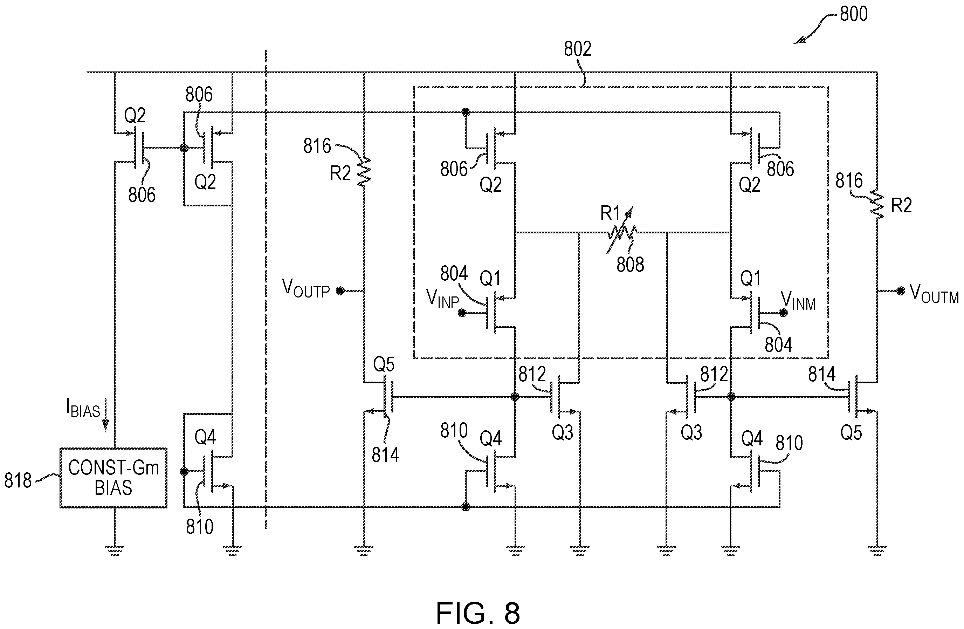

In some embodiments, the NMR application further implements a PGA in the RF receiver for adjusting the gain of the front-end components based on the amplitudes of the input signals, thereby enabling the amplitudes at the output of the receiver to be optimized for a wide dynamic range of input signals. FIG. 8 depicts an exemplary PGA 800 implemented in an RF receiver (or other sensors) in accordance with various embodiments of the present invention. In one embodiment, the PGA 800 includes an open-loop source-degenerated differential pair 802 having input devices (e.g., transistors 804, 806) for receiving input signals (e.g., RF signals). In addition, the PGA may include a programmable source-degeneration resistor 808 for setting the gain thereof - by varying the resistance R₁ of the programmable resistor 808, the gain of the PGA may be adjusted. In some embodiments, the PGA 800 further includes one or more devices (e.g., transistors) 810 for forcing the current flowing through the input transistors 804 to be constant. In addition, a super-gm feedback loop 812 may be added around the input transistors 804 to boost the effective transconductance of the input transistors 804 by the loop gain of the super-gm feedback loop 812. Because the current flowing through the input transistors 804 is constant, the input signals may appear fully across the resistor 808 and all the resulting AC currents can flow through the super-gm feedback transistors 812. The AC currents can then be mirrored, via one or more devices (e.g., transistors) 814, to one or more load resistors 816 having a resistance R₂; the load resistors 816 then convert the current back into a voltage signal at the output of the PGA 800.

In one embodiment, the super-gm feedback loop 812 includes one or more transistors; the loop gain can be determined by multiplying the parallel output impedance at the drains of the input transistors 804 and the transistors 810 by the transconductance of the super-gm feedback transistors 812. The boosted effective transconductance of the input transistors 804 may be closer to 1/Ri compared to that in the conventional open-loop PGA 160 (depicted in FIG. IE); this allows the gain steps of the PGA 800 to be better-defined based at least in part on the impedance of the programmable resistor 808. In addition, because the super-gm feedback loop 812 boosts the effective transconductance of the input transistors 804, the dependence of the overall effective transconductance of the source-degenerated differential pair 802 on the transconductance of the input transistors 804 may be significantly reduced. As a result, the dependence of the PGA gain on the PVT variations may be advantageously reduced, increasing the performance (e.g., linearity and/or stability) of the PGA 800 compared to the conventional open-loop PGA 160.

In various embodiments, the PGA 800 further includes a constant-transconductance (constant-gm) bias circuit 818 for reducing any residual dependence on the transconductance of the input transistors 804. The constant-gm bias circuit 818 may generate the bias currents of all the devices in the PGA 800 and may automatically adjust the bias currents so as to keep the transconductance of the input transistors 804 constant when changes in operating conditions, process, voltage and/or temperature occur. Accordingly, the impact on the PGA gain resulting from any residual dependence of the overall transconductance of the input differential pair on that of input transistors 804 may be advantageously avoided (or at least reduced). The constant-gm bias circuit can be any suitable design as is commonly implemented in many analog integrated-circuit applications (e.g., the constant-gm bias circuit described in "Razavi, B. (2001). Design of Analog CMOS Integrated Circuits. New York, NY: McGraw-Hill."), and thus is readily available and straightforwardly implemented.

Accordingly, the integrated PGA 800 described herein utilizes a super-gm feedback loop 812 and/or a constant-gm bias circuit 818 to beneficially increase the effective transconductance of the input differential pair to be closer to 1/Ri than is the case in conventional open-loop amplifiers. The boosted effective transconductance of the input differential pair may provide gain stability over different operating conditions and PVT variations. In one embodiment, the overall gain of the PGA 800 is determined based on the impedance ratio of the load resistors 816 to the programmable source-degeneration resistors 808 (i.e., R₂/R₁); as a result, the PGA gain can be accurately set by the resistance ratio of the two resistors and may be immune to changes in operating conditions and PVT variations. The PGA 800 described herein thus provides similar benefits as the closed-loop implementation 150 as illustrated in FIG. 1D. In addition, the PGA 800 described herein advantageously maintains the open-loop operation that leads to improved power efficiency and higher bandwidth capabilities. Further, the input transistors 804 may be made smaller while having larger effective transconductance than in other open-loop architectures; as a result, the preceding stage is loaded less, thereby allowing the PGA 800 to be designed with higher power efficiency for a given bandwidth.

It should be noted that the transistors 804, 806, 810, 812, 814 implemented in the PGA 800 may be any types of transistors, such as bipolar junction transistors (BJTs) or field-effect transistors (FETs). In one embodiment, the transistors are metal-oxide-semiconductor FETs (MOSFETs). In addition, embodiments of the PGA are not limited to implementations in RF receivers only and may be used in any suitable analog front-end components employed in various types of sensors. Further, NMR is an exemplary application that may beneficially utilize the PGA 800; one of ordinary skill in the art will understand that the sensor/receiver architecture described herein is suitable for many applications, which are thus within the scope of the invention.

The terms and expressions employed herein are used as terms and expressions of description and not of limitation, and there is no intention, in the use of such terms and expressions, of excluding any equivalents of the features shown and described or portions thereof. In addition, having described certain embodiments of the invention, it will be apparent to those of ordinary skill in the art that other embodiments incorporating the concepts disclosed herein may be used without departing from the spirit and scope of the invention. Accordingly, the described embodiments are to be considered in all respects as only illustrative and not restrictive. Further embodiments are disclosed in the following numbered examples.

Example 1. A sensor for receiving signals in integrated circuitry, the sensor comprising: circuitry for applying at least two successive stages of manipulation to the received signals; and an interface comprising an AC coupling network and buffer circuits for decoupling an output impedance and a first common-mode level of a first one of the two successive stages from an input impedance and a second common-mode level of a second one of the two successive stages without degrading the performance of either stage.

Example 2. The sensor of example 1, wherein the buffer circuits comprise source followers.

Example 3. The sensor of example 1, wherein the AC coupling network comprises at least one capacitor and at least one resistor.

Example 4. The sensor of example 1, wherein the at least two successive stages comprise one stage of amplification and one stage of frequency conversion.

Example 5. The sensor of example 4, wherein the stage of amplification comprises a programmable-gain amplifier.

Example 6. The sensor of example 4, wherein the stage of frequency conversion comprises a voltage-mode passive mixer.

Example 7. The sensor of example 1, wherein the at least two successive stages comprise two stages of amplification.

Example 8. The sensor of example 7, further comprising at least one switch connected to at least one of the two stages for providing a gain adjustment.

Example 9. The sensor of example 1, further comprising circuitry for applying a third stage of signal manipulation to the received signals, wherein the third stage and the first one of the two successive stages connect in parallel, via the interface, to the second one of the two successive stages.

Example 10. The sensor of example 9, wherein the third stage and the first one of the two successive stages comprise amplification stages and the second one of the two successive stages comprises a frequency-conversion stage.

Example 11. The sensor of example 9, wherein the third stage and the first one of the two successive stages comprise frequency-conversion stages and the second one of the two successive stages comprises an amplification stage.

Example 12. An NMR apparatus comprising: an NMR coil configured to enclose a sample; a receiver for receiving NMR signals from the sample, the receiver comprising (i) circuitry for applying at least two successive stages of manipulation to the received NMR signals, and (ii) an interface comprising an AC coupling network and buffer circuits for decoupling an output impedance and a first common-mode level of a first one of the two successive stages from an input impedance and a second common-mode level of a second one of the two successive stages without degrading the performance of either stage; and a controller configured to analyze the received NMR signals.

Example 13. The NMR apparatus of example 12, wherein the buffer circuits comprise source followers.

Example 14. The NMR apparatus of example 12, wherein the AC coupling network comprises at least one capacitor and at least one resistor.

Example 15. The NMR apparatus of example 12, wherein the two successive stages comprise one stage of amplification and one stage of frequency conversion.

Example 16. The NMR apparatus of example 12, wherein the two successive stages comprise two stages of amplification.

Example 17. The NMR apparatus of example 12, further comprising circuitry for applying a third stage of signal manipulation to the received NMR signals, wherein the third stage and the first one of the two successive stages connect in parallel, via the interface, to the second one of the two successive stages.

Example 18. The NMR apparatus of example 17, wherein the third stage and the first one of the two successive stages comprise amplification stages and the second one of the two successive stages comprises a frequency-conversion stage.

Example 19. The NMR apparatus of example 17, wherein the third stage and the first one of the two successive stages comprise frequency-conversion stages and the second one of the two successive stages comprises an amplification stage.

Example 20. A method of receiving signals in integrated circuitry, the method comprising: providing at least two successive stages of signal manipulation; and providing an interface for decoupling an output impedance and a first common-mode level of a first one of the two successive stages from an input impedance and a second common-mode level of a second one of the two successive stages without degrading the performance of either stage.

Example 21. A sensor for receiving signals in integrated circuitry, the sensor comprising: a voltage-mode passive mixer for down-converting one or more frequencies of the received signals; a baseband output buffer; and a transconductance amplifier coupled to the voltage-mode passive mixer for receiving output signals therefrom and coupled to the baseband output buffer for providing input signals thereto, the transconductance amplifier presenting a high-impedance load to the voltage-mode passive mixer and shielding the baseband output buffer from a high-frequency feedthrough.

Example 22. The sensor of example 21, wherein the voltage-mode passive mixer comprises a plurality of CMOS switches.

Example 23. The sensor of example 22, wherein the voltage-mode passive mixer comprises source followers for driving the CMOS switches.

Example 24. The sensor of example 23, wherein the voltage-mode passive mixer comprises at least one of AC coupling capacitors or DC bias resistors for rejecting a DC offset in the voltage-mode passive mixer.

Example 25. The sensor of example 21, further comprising one or more filter capacitors, located between the voltage-mode passive mixer and the baseband output buffer, for filtering an up-converted input signal.

Example 26. The sensor of example 21, further comprising a DAC for trimming an offset at an output of the baseband output buffer.

Example 27. The sensor of example 21, wherein the baseband output buffer comprises a transimpedance amplifier.

Example 28. The sensor of example 21, further comprising one or more feedback resistors coupled to the baseband output buffer for converting the input signals from a current domain to a voltage domain.

Example 29. An NMR apparatus comprising: an NMR coil configured to enclose a sample; a receiver for receiving NMR signals from the sample, the receiver comprising (i) a voltage-mode passive mixer for down-converting a frequency of the received NMR signals, (ii) a baseband output buffer, and (iii) a transconductance amplifier coupled to the voltage-mode passive mixer for receiving output signals therefrom and coupled to the baseband output buffer for providing input signals thereto, the transconductance amplifier presenting a high-impedance load to the voltage-mode mixer and shielding the baseband output buffer from a high-frequency feedthrough; and a controller configured to analyze the received NMR signals.

Example 30. The NMR apparatus of example 29, wherein the voltage-mode passive mixer comprises a plurality of CMOS switches.

Example 31. The NMR apparatus of example 30, wherein the voltage-mode passive mixer comprises source followers for driving the CMOS switches.

Example 32. The NMR apparatus of example 31, wherein the voltage-mode passive mixer comprises at least one of AC coupling capacitors or DC bias resistors for rejecting a DC offset in the voltage-mode passive mixer.

Example 33. The NMR apparatus of example 29, further comprising one or more filter capacitors, located between the voltage-mode passive mixer and the baseband output buffer, for filtering an up-converted input signal.

Example 34. The NMR apparatus of example 29, further comprising a DAC for trimming an offset at an output of the baseband output buffer.

Example 35. The NMR apparatus of example 29, wherein the baseband output buffer comprises a transimpedance amplifier.

Example 36. The NMR apparatus of example 29, further comprising one or more feedback resistors coupled to the baseband output buffer for converting the input signals from a current domain to a voltage domain.

Example 37. A method of receiving signals in integrated circuitry, the method comprising: providing a frequency-conversion means for down-converting a frequency of the received signals; providing a first amplification means for converting the signals from a current domain to the voltage domain; and providing a second amplification means coupled to the frequency-conversion means for receiving output signals therefrom and coupled to the first amplification means for providing input signals thereto, the second amplification means presenting a high-impedance load to the frequency-conversion means and shielding the first amplification means from a high-frequency feedthrough.

Example 38. A programmable gain amplifier (PGA) comprising: an open-loop source-degenerated amplifier comprising a pair of input devices; a pair of super-gm feedback loops, each coupled to one of the input devices for boosting an effective transconductance thereof; and a constant-gm bias circuit for setting a bias current of devices in the open-loop source-degenerated amplifier.

Example 39. The PGA of example 38, wherein the input devices comprise a source-degenerated differential pair.

Example 40. The PGA of example 38, wherein the open-loop source-degenerated amplifier comprises a programmable resistor for setting a gain of the PGA.

Example 41. The PGA of example 38, further comprising electronic devices for forcing a current flowing through the input devices to be constant.

Example 42. The PGA of example 41, wherein the electronic devices comprise transistors.

Example 43. The PGA of example 38, wherein the super-gm feedback loops comprise transistors.

Example 44. The PGA of example 38, wherein the constant-gm bias circuit is configured to automatically adjust the bias current so as to keep the effective transconductance of the input devices constant when changes in operating conditions, process, voltage or temperature occur.

Example 45. The PGA of example 38, further comprising a current mirror and a resistor for converting a current signal to a voltage signal at an output of the PGA.

Example 46. An NMR apparatus comprising: an NMR coil configured to enclose a sample; a receiver comprising an analog front-end structure and a PGA for adjusting a gain of the front-end structure based at least in part on an amplitude of NMR signals received from the sample, the PGA comprising (i) an open-loop source-degenerated amplifier comprising a pair of input devices, (ii) a pair of super-gm feedback loops, each coupled to one of the input devices for boosting an effective transconductance thereof, and (iii) a constant-gm bias circuit for setting a bias current of devices in the open-loop source-degenerated amplifier; and a controller configured to analyze the received NMR signals.

Example 47. The NMR apparatus of example 46, wherein the input devices comprise a source-degenerated differential pair.

Example 48. The NMR apparatus of example 46, wherein the open-loop source-degenerated amplifier comprises a programmable resistor for setting a gain of the PGA.

Example 49. The NMR apparatus of example 46, further comprising electronic devices for forcing a current flowing through the input devices to be constant.

Example 50. The NMR apparatus of example 49, wherein the electronic devices comprise transistors.

Example 51. The NMR apparatus of example 46, wherein the super-gm feedback loops comprise transistors.

Example 52. The NMR apparatus of example 46, wherein the constant-gm bias circuit is configured to automatically adjust the bias current so as to keep the effective transconductance of the input devices constant when changes in operating conditions, process, voltage or temperature occur.

Example 53. The NMR apparatus of example 46, further comprising a current mirror and a resistor for converting a current signal to a voltage signal at an output of the PGA.

Example 54. A method of adjusting a gain of received signals in integrated circuitry, the method comprising: amplifying the received signals using an open-loop source-degenerated amplifier comprising a pair of input devices; boosting an effective transconductance of the input devices; and setting a bias current of devices in the open-loop source-degenerated amplifier.

## Claims

1. A sensor for receiving signals in integrated circuitry, the sensor comprising:
circuitry for applying at least two successive stages (304, 306, 308, 310) of manipulation to the received signals; and
an interface (302) comprising an AC coupling network (312) and buffer circuits (314) for decoupling an output impedance and a first common-mode level of a first one of the two successive stages (304, 306, 308, 310) from an input impedance and a second common-mode level of a second one of the two successive stages (304, 306, 308, 310) without degrading the performance of either stage.

2. The sensor of claim 1, wherein the buffer circuits (314) comprise source followers (706).

3. The sensor of claim 1, wherein the AC coupling network (312) comprises at least one capacitor (712) and at least one resistor (714).

4. The sensor of claim 1, wherein the at least two successive stages (304, 306, 308, 310) comprise one stage of amplification (308) and one stage of frequency conversion (310).

5. The sensor of claim 4, wherein the stage of amplification comprises a programmable-gain amplifier (800).

6. The sensor of claim 4, wherein the stage of frequency conversion (310) comprises a voltage-mode passive mixer (402).

7. The sensor of claim 1, wherein the at least two successive stages (304, 306, 308, 310) comprise two stages of amplification (304, 306).

8. The sensor of claim 7, further comprising at least one switch (316) connected to at least one of the two stages for providing a gain adjustment.

9. The sensor of claim 1, further comprising circuitry for applying a third stage of signal manipulation to the received signals, wherein the third stage and the first one of the two successive stages (304, 306, 308, 310) connect in parallel, via the interface (302), to the second one of the two successive stages (304, 306, 308, 310).

10. The sensor of claim 9, wherein the third stage and the first one of the two successive stages (304, 306, 308, 310) comprise amplification stages and the second one of the two successive stages (304, 306, 308, 310) comprises a frequency-conversion stage.

11. The sensor of claim 9, wherein the third stage and the first one of the two successive stages (304, 306, 308, 310) comprise frequency-conversion stages and the second one of the two successive stages (304, 306, 308, 310) comprises an amplification stage.

12. An NMR apparatus (200) comprising:
an NMR coil (202) configured to enclose a sample (204);
a receiver (214) for receiving NMR signals from the sample, the receiver (214) comprising the sensor of any of the preceding claims, the circuitry of the sensor for applying the at least two successive stages (304, 306, 308, 310) of manipulation to the received NMR signals; and
a controller (210) configured to analyze the received NMR signals.

13. A method of receiving signals in integrated circuitry, the method comprising:
providing at least two successive stages (304, 306, 308, 310) of signal manipulation; and
providing an interface (302) for decoupling an output impedance and a first common-mode level of a first one of the two successive stages (304, 306, 308, 310) from an input impedance and a second common-mode level of a second one of the two successive stages (304, 306, 308, 310) without degrading the performance of either stage.
